(19) Europäisches Patentamt

European Patent Office

Office européen des brevets

(11) **EP 2 529 242 B1**

(12) **FASCICULE DE BREVET EUROPEEN**

(45) Date de publication et mention
de la délivrance du brevet:
**14.04.2021 Bulletin 2021/15**

(51) Int Cl.:
***G01R 31/392*** (2019.01)

(21) Numéro de dépôt: **11708898.9**

(22) Date de dépôt: **26.01.2011**

(86) Numéro de dépôt international:
**PCT/FR2011/000051**

(87) Numéro de publication internationale:
**WO 2011/092403 (04.08.2011 Gazette 2011/31)**

(54) **PROCÉDÉ DE DIAGNOSTIC DE L'ÉTAT DE SANTÉ D'UNE BATTERIE**

VERFAHREN ZUR DIAGNOSTIZIERUNG DES GESUNDHEITSZUSTANDS EINER BATTERIE

METHOD FOR DIAGNOSING THE STATE OF HEALTH OF A BATTERY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.01.2010 FR 1000311**

(43) Date de publication de la demande:
**05.12.2012 Bulletin 2012/49**

(73) Titulaire: **Commissariat à l'Énergie Atomique
et aux Énergies Alternatives
75015 Paris (FR)**

(72) Inventeur: **KIRCHEV, Angel Zhivkov
F-73100 Aix-les-Bains (FR)**

(74) Mandataire: **Talbot, Alexandre et al
Cabinet Hecké
28 Cours Jean Jaurès
38000 Grenoble (FR)**

(56) Documents cités:
**WO-A1-2006/107247        WO-A2-2009/158226
JP-A- 7 183 050             JP-B2- 2 979 938
US-A- 4 912 416            US-A1- 2007 194 756**

• **MEISSNER E ET AL: "Battery Monitoring and
Electrical Energy Management - Precondition for
future vehicle electric power systems",
JOURNAL OF POWER SOURCES, ELSEVIER SA,
CH LNKD- DOI:10.1016/S0378-7753(02)00713-9,
vol. 116, no. 1-2, 1 juillet 2003 (2003-07-01), pages
79-98, XP004433272, ISSN: 0378-7753 cité dans
la demande**

EP 2 529 242 B1

## Description

## Domaine technique de l'invention

L'invention est relative à un procédé de diagnostic de l'état de santé (SOH) d'une batterie.

## État de la technique

Le stockage d'énergie nécessite une surveillance régulière des batteries par le biais de tests afin de déterminer les batteries défaillantes. L'incapacité d'une batterie à fournir l'énergie demandée est une première indication de sa détérioration. Le test d'une batterie peut être réalisé en déterminant son état de santé (SOH, « state of health » en anglais). L'état de santé SOH est généralement représentatif de la condition d'une batterie, de sa détérioration ou de sa capacité à fournir le courant voulu.

L'état de santé peut être exprimé par la capacité de décharge $C_D$ normalisée par la capacité nominale de la batterie $C_N$. La capacité de décharge $C_D$ représente la quantité d'énergie qu'une batterie peut subir en décharge après avoir été complètement chargée. Ainsi, plus la capacité de décharge est proche de la capacité nominale de la batterie, meilleur est son état de santé. Selon cette définition, l'état de santé s'écrit par la relation suivante :

$$\text{SOH} = 100 \cdot \frac{C_D}{C_N} \qquad \text{(R1)}$$

Une baisse de l'état de santé représente une perte irréversible de capacité due à différents phénomènes de dégradation tels que la sulfatation de la batterie. Le SOH est déterminé, de manière classique, par la décharge complète d'une batterie ayant été précédemment chargée en totalité. Le courant de décharge est constant et traditionnellement égal à $C_N/20h$, avec $C_N$ la capacité nominale de la batterie.

Utiliser cette définition directement pour mesurer l'état de santé d'une batterie n'est pas applicable dans une situation réelle. En effet, il faudrait régulièrement procéder à la décharge de chaque batterie d'un parc pendant une vingtaine d'heures, ce qui réduit l'efficacité d'utilisation du parc.

Les méthodes classiques de test rapide d'état de santé effectuent une mesure de la tension de circuit ouvert (« open-circuit voltage », en anglais, OCV) et une mesure de la résistance interne de la batterie, à partir de signaux alternatifs de faible amplitude ou à partir de pulsations de courant en créneaux.

Le document US4912416 décrit l'un de ces dispositifs de test de batteries. Le dispositif mesure la conductance dynamique d'une batterie (c'est-à-dire l'inverse de la résistance interne), représentative de sa condition électrique. La conductance de la batterie étant dépendante de son état de charge (« state of charge » en anglais, SOC), celui-ci est également évalué pour corriger la valeur de la conductance. L'état de charge est généralement déterminé par la mesure de la tension de circuit ouvert Vco aux bornes de la batterie.

Ces techniques de test de l'état de santé présentent néanmoins des inconvénients. La tension de circuit ouvert utilisée pour déterminer l'état de charge est une représentation approximative de l'état de santé de la batterie. En effet, une batterie chargée ayant un SOH faible peut avoir une tension de circuit ouvert sensiblement égale, voire supérieure, à celle d'une batterie neuve. De plus, la résistance interne d'une batterie ne tient compte que des composants ohmiques de celle-ci. Les résistances des collecteurs de courant métalliques, le volume d'électrolyte et la résistance des matériaux actifs ne participant pas aux réactions ne sont pas pris en compte dans la mesure de la résistance interne. La résistance de transfert de charge est, par exemple, omise.

En revanche, la mesure tient compte des résistances dites de contact correspondant aux connexions avec le dispositif de test. Si la qualité du contact est mauvaise, l'erreur sur la mesure peut être significative.

Le document JP2979938 décrit la décharge d'une batterie avec plusieurs phases de décharge consécutives à courant constant. La valeur de tension est mesurée à la fin de chaque phase de décharge. La valeur de tension est comparée à la valeur de tension lors de phase de charge précédente pour déterminer si ses deux valeurs sont sensiblement identiques. Si les deux valeurs ne sont pas identiques, la batterie est considérée en fin de vie. Si les deux valeurs sont identiques, la valeur de tension en circuit ouvert et la valeur de tension en fin de décharge sont calculées pour la phase de décharge suivante et la différence de tension est comparée à une valeur de référence pour déterminer si la batterie a atteint sa fin de vie.

Le document US2007/0194756 décrit une méthode pour déterminer l'état de santé d'une batterie à partir de la différence entre une valeur calculée de l'état de charge et une valeur mesurée de l'état de charge. Elle repose sur le fait que, au fil du temps, la santé de la batterie se dégrade et la valeur théorique de l'état de charge diffère de la valeur mesurée. La valeur mesurée de l'état de charge est obtenue en mesurant la tension en circuit ouvert.

Cette méthode est longue à mettre en œuvre car elle requiert plusieurs étapes de décharge successives. En effet, l'état de santé de la batterie est déterminé à l'issue de plusieurs itérations correspondant chacune à une étape de décharge. La valeur de l'état de santé est actualisée après chaque décharge, en comparant la valeur mesurée de l'état de charge à la valeur attendue, théorique, de l'état de charge (qui elle-même dépend de la valeur de l'état de santé calculé à l'itération précédente).

**Résumé de l'invention**

L'invention vise un procédé de diagnostic de l'état de santé simple, rapide et qui ne nécessite pas une décharge importante de la batterie.

Selon l'invention, on tend vers cet objectif par les revendications annexées.

**Description sommaire des dessins**

D'autres avantages et caractéristiques ressortiront plus clairement de la description qui va suivre de modes particuliers de réalisation donnés à titre d'exemples non limitatifs et illustrés à l'aide des dessins annexés, dans lesquels :

- la figure 1 représente des étapes d'un procédé de diagnostic de l'état de santé selon l'invention,

- la figure 2 représente un détail d'étape du procédé selon la figure 1,

- les figures 3 et 4 représentent la tension $V_{cell}$ aux bornes d'une cellule électrochimique de test lors d'une décharge continue à courant constant et lors d'une décharge à courant constant interrompue par des périodes de circuit ouvert,

- la figure 5 représente un détail d'étape du procédé selon la figure 1,

- la figure 6 représente la tension en circuit ouvert Vco de la cellule en fonction de son état de charge $SOC^2$, pour différents temps de relaxation $t_2$ de la batterie, et

- la figure 7 représente, de manière schématique, un dispositif de test pour la mise en œuvre du procédé selon l'invention.

**Description d'un mode de réalisation préféré de l'invention**

L'état de charge (SOC) représente la quantité d'électricité (exprimée en Ah) stockée dans une batterie normalisée par la quantité maximale qui peut être stockée après une charge complète de la batterie. Deux techniques peuvent être employées pour déterminer l'état de charge SOC d'une batterie.

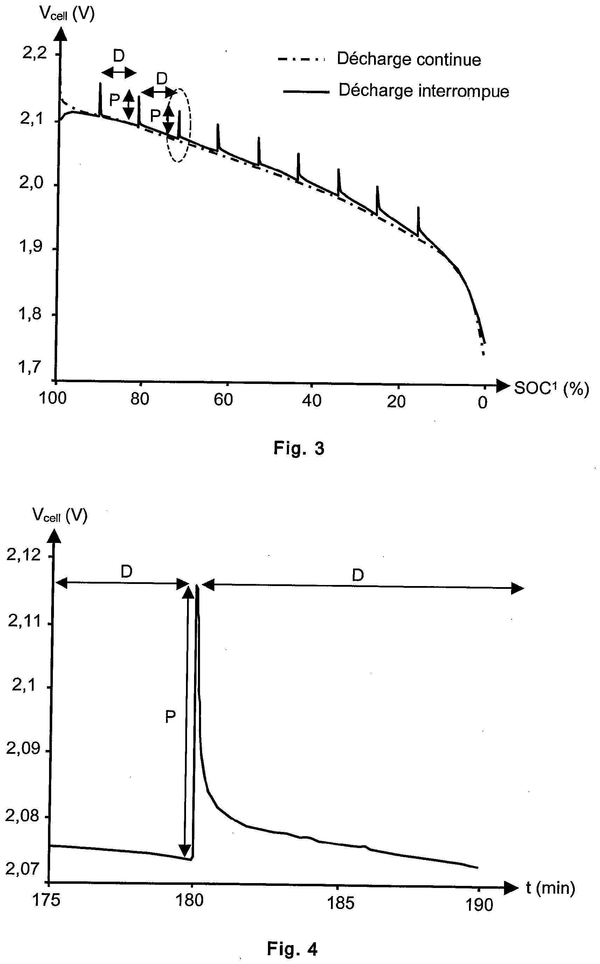

Une première technique consiste à mesurer la tension aux bornes de la batterie lors d'une décharge partielle à courant constant de la batterie. La valeur de la tension permet de déterminer l'état de charge de la batterie à l'aide d'abaques. Les abaques (comme celui représenté à la figure 3) sont généralement établis en mesurant la quantité déchargée $Q_D$ par ampérométrie.

Il s'avère que l'état de charge $SOC^1$ ainsi déterminé peut s'écrire de la manière suivante :

$$SOC^1 = 100 \cdot \frac{\left(C_D - Q_D\right)}{C_D} \qquad \text{(R2),}$$

où $C_D$ est la capacité de décharge maximale et $Q_D$ la quantité d'énergie déchargée ($C_D$ et $Q_D$ en Ah). Cette première valeur de SOC est donc normalisée par la capacité de décharge $C_D$.

Une seconde technique de détermination de l'état de charge utilise une mesure de la tension de la batterie en circuit ouvert Vco. Dans le cas des batteries acide-plomb, cette technique repose sur la relation quasi-linéaire entre la concentration d'acide sulfurique dans l'électrolyte (ou la densité de l'électrolyte) et la force électromotrice E de la batterie. Après un temps de relaxation suffisamment long après l'ouverture du circuit, la tension de circuit ouvert Vco aux bornes de la batterie se stabilise à une valeur proche de la force électromotrice E de la batterie. Par ailleurs, l'acide sulfurique de l'électrolyte est un composant actif de la batterie, consommé lors d'une décharge et régénéré lors d'une charge. Ainsi, la concentration en acide est proportionnelle à l'état de charge SOC de la batterie. Une relation quasi-linéaire entre l'état de charge SOC et la tension de circuit ouvert Vco dite « équilibrée » est ainsi obtenue. Cette relation est explicitée, par exemple, dans l'article « Battery monitoring and electrical energy management precondition for future vehicle electric power systems » (Meissner et al., Journal of Power Sources, 116, 79-98, 2003).

Lorsque l'état de charge est déterminé par la mesure de la tension en circuit ouvert Vco à l'équilibre, il peut être exprimé par la relation suivante :

$$SOC^2 = 100 \cdot \frac{(C_N - Q_D)}{C_N} \qquad (R3),$$

avec $C_N$ la capacité nominale de la batterie et $Q_D$ la quantité d'énergie déchargée.

L'état de charge selon la relation R3 est normalisé par rapport à la capacité nominale $C_N$ puisque l'état de charge maximum correspond à la concentration en acide sulfurique (ou densité de l'électrolyte) maximale.

Il a été découvert par les inventeurs que l'état de santé (SOH) d'une batterie peut être estimé à l'aide de ces deux mesures de l'état de charge. En effet, la relation R2 exprimant la première valeur de l'état de charge $SOC^1$ comprend des informations sur l'état de santé SOH de la batterie puisque la capacité de décharge $C_D$ varie en fonction de la détérioration de la batterie. A titre d'exemple, la capacité $C_D$ diminue dans le temps si la batterie est soumise à des phénomènes de corrosion des grilles ou de dégradation du matériau actif de la batterie. A l'inverse, la relation R3 exprimant la seconde valeur $SOC^2$ ne tient pas compte du vieillissement de la batterie, c'est-à-dire que cette relation est fiable si la batterie est scellée (sans maintenance) ou si la maintenance de la batterie est régulièrement effectuée. La seconde valeur $SOC^2$ reflète donc des informations sur l'état initial de la batterie. Ainsi, ces deux méthodes de calcul de l'état de charge ne donnent pas la même valeur suivant l'état de santé de la batterie.

Il est possible de retrouver la définition de l'état de santé selon la relation R1 par une relation basée sur la différence entre $SOC^2$ et $SOC^1$.

D'après les relations R2 et R3, la différence $SOC^2$-$SOC^1$ s'écrit :

$$\Delta SOC = SOC^2 - SOC^1 = 100 \cdot \left[ \frac{(C_N - Q_D)}{C_N} - \frac{(C_D - Q_D)}{C_D} \right] \qquad (R4)$$

La relation R4 se simplifie de la manière suivante :

$$\Delta SOC = 100 \cdot Q_D \cdot \left( \frac{1}{C_D} - \frac{1}{C_N} \right) = 100 \cdot \frac{Q_D}{C_D} \cdot \left( 1 - \frac{C_D}{C_N} \right) \qquad (R5)$$

Avec $\dfrac{C_D}{C_N} = \dfrac{SOH}{100}$ d'après la relation R1 et $\dfrac{Q_D}{C_D} = 1 - \dfrac{SOC^1}{100}$ d'après la relation R2, on obtient :

$$SOH = 100 - \frac{100 \cdot (SOC^2 - SOC^1)}{100 - SOC^1} \qquad (R6)$$

On établit ainsi une relation permettant de calculer l'état de santé SOH à partir de la différence entre deux valeurs de l'état de charge, déterminées selon des techniques distinctes ne nécessitant pas un cycle de charge-décharge complet. Il est proposé de mettre en application ce constat à l'aide d'un procédé de diagnostic décrit ci-dessous.

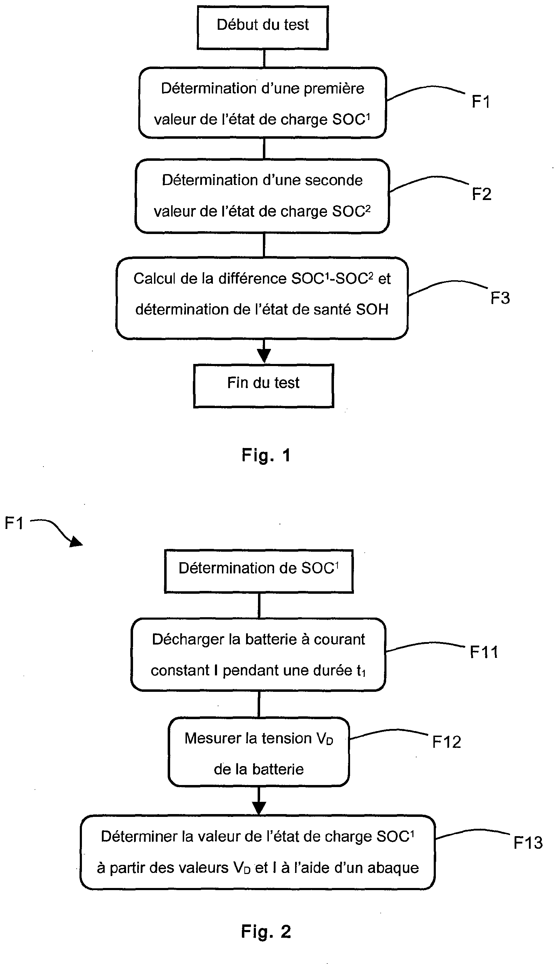

La figure 1 représente des étapes génériques d'un procédé de diagnostic de l'état de santé SOH d'une batterie. Dans une étape F1, une première valeur $SOC^1$ de l'état de charge de la batterie est déterminée à partir de la tension $V_D$ obtenue après une décharge partielle de la batterie à courant constant. En F2, une seconde valeur $SOC^2$ de l'état de charge est déterminée à partir de la tension de circuit ouvert $V_{CO}$ de la batterie. En F3, la différence $SOC^2$-$SOC^1$ est calculée puis utilisée pour déterminer l'état de santé SOH à l'aide de la relation R6.

La figure 2 représente un exemple détaillé de l'étape F1 du procédé de diagnostic de la figure 1. Dans une étape F11, la batterie est déchargée pendant une durée $t_1$ par un courant I constant. Dans une étape F12, la tension $V_D$ aux bornes de la batterie est mesurée à la fin de la décharge. A l'étape F13, on utilise un abaque, établi au préalable à l'aide de batteries étalon et fournissant les valeurs de l'état de charge $SOC^1$ en fonction des différentes tensions de décharge $V_D$ et différentes densités de courant. Ainsi, la première valeur $SOC^1$ de l'état de charge est obtenue en lisant l'abaque pour la tension de décharge $V_D$ mesurée en F12 et le courant de décharge I appliqué en F11.

Le courant de décharge I peut être compris entre $C_N/10$ h et $C_N/1$ h, $C_N$ étant la capacité nominale de la batterie. De préférence, le courant I est compris entre $C_N/5$ h et $C_N/3$ h. La durée $t_1$ de la décharge est choisie de manière que la diminution de la charge de la batterie soit comprise entre 0,5% et 2%. La quantité d'énergie consommée pour le test reste donc limitée et l'utilisation ultérieure de la batterie est préservée. La durée $t_1$ de la décharge est comprise entre 20 secondes et 10 minutes, de préférence entre 1 et 3 minutes. A titre d'exemple, une décharge de test d'une durée de 3 minutes à un courant de $C_N/5$ h décharge la batterie de 1 % de sa capacité.

La figure 3 représente la tension $V_{cell}$ aux bornes d'une cellule électrochimique de batterie selon deux types de décharge. La cellule utilisée pour ces essais expérimentaux est une cellule de batterie acide-plomb à valve (« Valve Regulated Lead-Acid Batteries » ou VRLAB) du fabricant Sonnenschein. Cette cellule comporte un électrolyte sous forme de gel et sa capacité nominale est de l'ordre de 10 A.h.

La courbe en pointillés représente une décharge continue à courant constant de 1 A classiquement réalisée pour déterminer l'état de charge $SOC^1$. Pendant cette décharge continue, la tension de la cellule $V_{cell}$ varie de manière quasi-linéaire pour des valeurs de l'état de charge $SOC^1$ comprises entre 20 % et 90 %. La pente de la courbe est de l'ordre de 2,3 mV/% pour une cellule. A une valeur de $V_{cell}$ mesurée peut être associée une valeur de l'état de charge $SOC^1$, avec une précision de l'ordre de 0,5 % à 1 %.

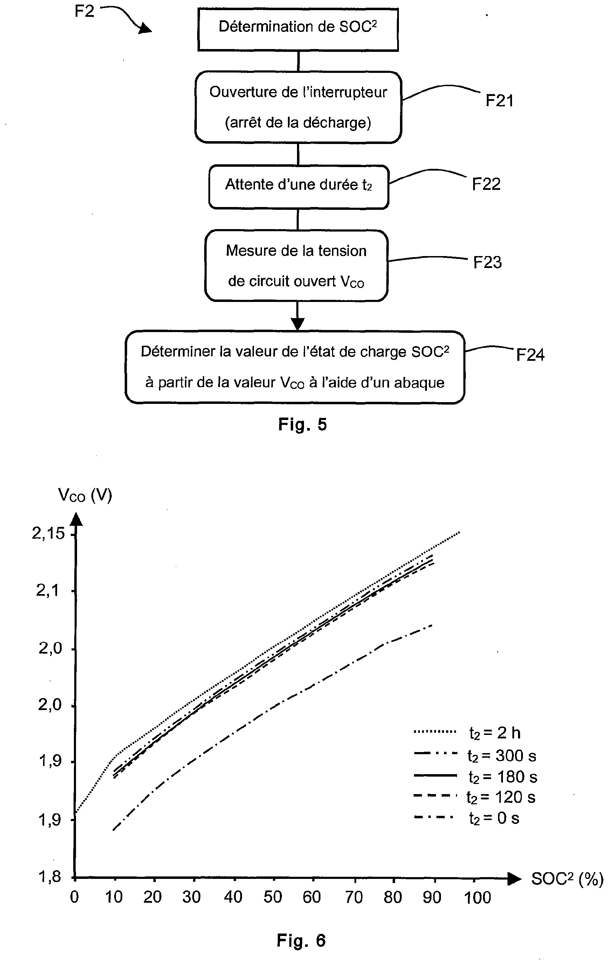

La courbe en trait plein représente, dans des conditions expérimentales, l'évolution de la tension de la cellule $V_{cell}$ selon le procédé de diagnostic représenté à la figure 1, pour déterminer chacune des valeurs de l'état de charge $SOC^1$ et $SOC^2$. La décharge D de la batterie est interrompue par des périodes P pendant lesquelles le circuit d'alimentation est ouvert. Pour que les allures des deux courbes soient comparables, la durée des périodes P a été représentée comme nulle, et on n'aperçoit à la figure 3 que la variation de tension sur chaque période P. Une période de décharge D à courant constant de 1 A permet une évaluation de la valeur $SOC^1$ selon l'étape F1 (Fig.2) tandis qu'une période P de circuit ouvert permet une évaluation de la valeur $SOC^2$ selon l'étape F2, qui sera explicitée ci-après à l'aide de la figure 5. Chaque période P de circuit ouvert correspond à un pic de la tension de la cellule. En effet, lors d'une déconnexion de la cellule après une décharge, la tension en circuit ouvert $V_{CO} = V_{cell}$ remonte vers une valeur d'équilibre. La décharge D redémarre alors à partir de cette valeur. La figure 3 montre que dans le cas d'interruptions de la décharge (courbe en trait plein), sans tenir compte de la durée des interruptions, la tension de la cellule reste proche de celle liée à une décharge sans interruptions (courbe en pointillés).

La figure 4 représente, en vue agrandie, une période P de circuit ouvert suivie d'une période de décharge D, à une valeur de l'état de charge $SOC^1$ d'environ 72 %. Après ouverture du circuit d'alimentation et stabilisation de la tension aux bornes de la cellule, la tension $V_{cell}$ est à son maximum. Lorsque la décharge D reprend, la tension diminue rapidement et atteint en quelques minutes une valeur proche de celle obtenue dans le cas d'une décharge ininterrompue.

Les figures 3 et 4 montrent donc que la déconnexion temporaire de la batterie, servant à l'évaluation de la valeur $SOC^2$, influe peu sur la tension $V_D = V_{cell}$ de la cellule lors de la décharge D, et donc sur la détermination de la première valeur de l'état de charge $SOC^1$. Le procédé de diagnostic de l'état de santé peut donc être employé à plusieurs reprises de façon fiable, comme schématisé sur la figure 3.

La figure 5 représente un exemple détaillé de l'étape F2 de détermination de la seconde valeur $SOC^2$ de l'état de charge. La décharge de l'étape F1 est suivie par l'ouverture du circuit lors d'une étape F21. L'état du circuit reste inchangé pendant une durée $t_2$ (étape F22). Pendant cette période, la tension de circuit ouvert $V_{CO}$ atteint un état d'équilibre, c'est-à-dire une valeur proche de la force électromotrice E de la batterie. Enfin, la tension de circuit ouvert $V_{CO}$ à l'équilibre est mesurée (étape F23) et utilisée dans un second abaque lors d'une étape F24. Cet abaque regroupe les valeurs de la tension de circuit ouvert $V_{CO}$ à l'équilibre d'une batterie étalon en correspondance avec les valeurs de l'état de charge $SOC^2$.

Comme décrit précédemment, la tension de circuit ouvert $V_{CO}$ ou tension à vide atteint un état stationnaire après un temps de relaxation. Pour permettre une évaluation précise de l'état de charge $SOC^2$, l'étape de mesure de la tension $V_{CO}$ est généralement réalisée après une durée d'attente de deux heures après déconnexion de la batterie. Ce délai d'attente est évidemment trop long pour une mise en œuvre dans un parc de batteries commercial. On verra ci-après une solution pour raccourcir ce délai.

La figure 6 représente la tension de circuit ouvert Vco de la cellule précédemment décrite en fonction de l'état de charge $SOC^2$, pour des temps de relaxation $t_2$ variant de 0 à 2 h. La valeur maximale de la tension Vco est atteinte pour $t_2$ = 2 h. On remarque qu'un temps de relaxation de l'ordre de 120 secondes permet d'atteindre une valeur de tension à vide de l'ordre de 90 % de la valeur maximale.

Ainsi, la durée d'attente ou temps de relaxation $t_2$ est choisi, de préférence, entre 120 et 300 secondes pour minimiser la durée du procédé de diagnostic et conserver une bonne précision. La tension de circuit ouvert $V_{CO}$ est donc mesurée, de préférence, 120 à 300 secondes après la fin de la décharge partielle et l'ouverture du circuit.

Le procédé de diagnostic de l'état de santé est rapide puisque quelques minutes suffisent à calculer chacune des valeurs de l'état de charge. Pour une décharge partielle d'environ trois minutes suivie d'une période de circuit ouvert d'environ deux minutes, le procédé de diagnostic de l'état de santé a une durée de l'ordre de six minutes, y compris le temps nécessaire aux calculs de la valeur SOH. Par ailleurs, le procédé ne décharge pas la batterie de manière significative, puisque une décharge de 0,5 % à 2 % est suffisante pour déterminer la première valeur de l'état de charge $SOC^1$.

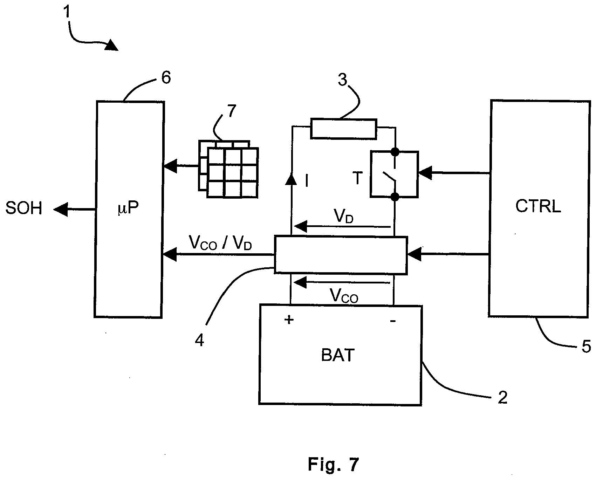

La figure 7 représente un dispositif de test 1 pour la mise en œuvre du procédé de diagnostic selon la figure 1. Une batterie 2 est reliée à une charge 3, par exemple une résistance. Un interrupteur T est connecté en série entre la batterie 1 et la charge 3 pour placer la batterie 2 en circuit ouvert ou fermé. Le dispositif comporte, de plus, un circuit de mesure 4 de la tension $V_D$ aux bornes de la charge 3 ou de la tension de circuit ouvert $V_{CO}$. Le circuit de mesure 4 et l'interrupteur T sont commandés par une unité de commande 5.

Les tensions $V_D$ et Vco sont fournies par le circuit de mesure 4 à un calculateur 6, par exemple un microprocesseur. A partir des tensions $V_D$ et Vco et d'abaques 7 contenus dans une mémoire, le calculateur 6 détermine l'état de santé SOH de la batterie 2.

De nombreuses variantes et modifications apparaîtront à l'homme du métier. En particulier, le procédé de diagnostic de l'état de santé pourra être appliqué à une batterie totalement chargée, à une batterie partiellement ou totalement déchargée.

## Revendications

1. Procédé de diagnostic de l'état de santé (SOH) d'une batterie mis en œuvre par un dispositif de test (1), comprenant les étapes suivantes :

   - déterminer (F1) une première valeur de tension ($V_D$) de la batterie lors d'une décharge partielle à courant constant (I),
   - déterminer (F2) une seconde valeur de tension de circuit ouvert ($V_{CO}$) de la batterie, et
   - déduire (F3) l'état de santé (SOH),

   procédé **caractérisé en ce qu'**une première valeur d'état de charge ($SOC^1$) est déterminée à partir de la première valeur de tension ($V_D$), une seconde valeur de l'état de charge ($SOC^2$) est déterminée à partir de la seconde valeur de tension de circuit ouvert ($V_{CO}$) et **en ce que** l'état de santé SOH est calculé à partir de la relation

$$SOH = 100 - \frac{100 \cdot \left( SOC^2 - SOC^1 \right)}{100 - SOC^1},$$

   où $SOC^1$ est la première valeur de l'état de charge et $SOC^2$ est la seconde valeur de l'état de charge.

2. Procédé selon la revendication 1, **caractérisé en ce que** le courant de décharge partielle (I) est compris entre $C_N/10$ h et $C_N/1$ h, $C_N$ étant la capacité nominale de la batterie.

3. Procédé selon la revendication 2, **caractérisé en ce que** le courant de décharge partielle (I) est compris entre $C_N/5$ h et $C_N/3$ h.

4. Procédé selon la revendication 1, **caractérisé en ce que** la décharge partielle a lieu pendant une durée ($t_1$) telle que la diminution de la charge de la batterie est comprise entre 0,5% et 2%.

5. Procédé selon la revendication 1, **caractérisé en ce que** la décharge partielle a lieu pendant une durée ($t_1$) comprise entre 20 secondes et 10 minutes.

6. Procédé selon la revendication 5, **caractérisé en ce que** la durée de la décharge partielle ($t_1$) est comprise entre 1 minute et 3 minutes.

7. Procédé selon la revendication 1, **caractérisé en ce que** l'étape (F2) de détermination de la seconde valeur de l'état de charge ($SOC^2$) comprend les étapes suivantes :

   - déconnecter la batterie pendant une durée ($t_2$) comprise entre 60 à 300 secondes, et
   - mesurer la tension de circuit ouvert (Vco) de la batterie.

**Patentansprüche**

1. Verfahren zur Diagnostizierung des Gesundheitszustands (SOH) einer Batterie, das durch eine Prüfvorrichtung (1) ausgeführt wird, umfassend die folgenden Schritte:

   - Bestimmen (F1) eines ersten Spannungswerts ($V_D$) der Batterie bei einer Teilentladung mit konstantem Strom (I),
   - Bestimmen (F2) eines zweiten Leerlaufspannungswerts ($V_{CO}$) der Batterie, und
   - Ableiten (F3) des Gesundheitszustands (SOH),

   wobei das Verfahren **dadurch gekennzeichnet ist, dass** ein erster Ladungszustandswert ($SOC^1$) ausgehend von dem ersten Spannungswert ($V_D$) bestimmt wird und ein zweiter Ladungszustandswert ($SOC^2$) ausgehend von dem zweiten Leerlaufspannungswert ($V_{co}$) bestimmt wird und dass der Gesundheitszustand SOH ausgehend von der Relation

$$ SOH = 100 - \frac{100 \cdot (SOC^2 - SOC^1)}{100 - SOC^1} $$

   bestimmt wird, wobei $SOC^1$ der erste Ladungszustandswert ist und $SOC^2$ der zweite Ladungszustandswert ist.

2. Verfahren nach Anspruch 1, **dadurch gekennzeichnet, dass** der Teilentladungsstrom (I) zwischen $C_N/10$ h und $C_N/1$ h beträgt, wobei $C_N$ die Nennkapazität der Batterie ist.

3. Verfahren nach Anspruch 2, **dadurch gekennzeichnet, dass** der Teilentladungsstrom (1) zwischen $C_N/5$ h und $C_N/3$ h beträgt.

4. Verfahren nach Anspruch 1, **dadurch gekennzeichnet, dass** die Teilentladung während einer derartigen Dauer ($t_1$) stattfindet, dass die Verringerung der Ladung der Batterie zwischen 0,5 % und 2 % beträgt.

5. Verfahren nach Anspruch 1, **dadurch gekennzeichnet, dass** die Teilentladung während einer Dauer ($t_1$) stattfindet, die zwischen 20 Sekunden und 10 Minuten beträgt.

6. Verfahren nach Anspruch 5, **dadurch gekennzeichnet, dass** die Dauer der Teilentladung ($t_1$) zwischen 1 Minute und 3 Minuten beträgt.

7. Verfahren nach Anspruch 1, **dadurch gekennzeichnet, dass** der Schritt (F2) des Bestimmens des zweiten Ladungszustandswerts ($SOC^2$) die folgenden Schritte umfasst:

   - Abklemmen der Batterie während einer Dauer ($t_2$) zwischen 60 und 300 Sekunden, und
   - Messen der Leerlaufspannung ($V_{co}$) der Batterie.

**Claims**

1. Method for diagnosing the state of health (SOH) of a battery implemented by a test device (1), comprising the following steps:

   - determining (F1) a first voltage value ($V_D$) of the battery during partial discharge at a constant current (I),
   - determining (F2) a second open circuit voltage value (Vco) of the battery, and
   - deducing (F3) the state of health (SOH),

   method **characterized in that** a first state of charge value ($SOC^1$) is determined from the first voltage value ($V_D$), a second state of charge value ($SOC^2$) is determined from the second open circuit voltage value ($V_{CO}$) and **in that** the state of health SOH is calculated from the relationship

$$SOH = 100 - \frac{100 \cdot \left(SOC^2 - SOC^1\right)}{100 - SOC^1},$$

where $SOC^1$ is the first state-of-charge value and $SOC^2$ is the second state-of-charge value.

2. Method according to claim 1, **characterized in that** the partial discharge current (I) is comprised between $C_N/10$ h and $C_N/1$h, $C_N$ being the nominal capacity of the battery.

3. Method according to claim 2, **characterized in that** the partial discharge current (I) is comprised between $C_N/5$ h and $C_N/3$ h.

4. Method according to claim 1, **characterized in that** partial discharge takes place during a time period ($t_1$) such that the decrease of the charge of the battery is comprised between 0.5 % and 2 %.

5. Method according to claim 1, **characterized in that** partial discharge takes place during a time period ($t_1$) comprised between 20 seconds and 10 minutes.

6. Method according to claim 5, **characterized in that** the partial discharge time period ($t_1$) is comprised between 1 minute and 3 minutes.

7. Method according to claim 1, **characterized in that** the step (F2) of determining the second state-of-charge value ($SOC^2$) comprises the following steps:

   - disconnecting the battery during a time period ($t_2$) comprised between 60 and 300 seconds, and
   - measuring the open circuit voltage (Vco) of the battery.

Début du test

Détermination d'une première
valeur de l'état de charge SOC¹ — F1

Détermination d'une seconde
valeur de l'état de charge SOC² — F2

Calcul de la différence SOC¹-SOC² et
détermination de l'état de santé SOH — F3

Fin du test

**Fig. 1**

F1

Détermination de SOC¹

Décharger la batterie à courant
constant I pendant une durée $t_1$ — F11

Mesurer la tension $V_D$
de la batterie — F12

Déterminer la valeur de l'état de charge SOC¹
à partir des valeurs $V_D$ et I à l'aide d'un abaque — F13

**Fig. 2**

**Fig. 3**

**Fig. 4**

F2

Détermination de SOC$^2$

Ouverture de l'interrupteur

(arrêt de la décharge) — F21

Attente d'une durée $t_2$ — F22

Mesure de la tension

de circuit ouvert $V_{CO}$ — F23

Déterminer la valeur de l'état de charge SOC$^2$

à partir de la valeur $V_{CO}$ à l'aide d'un abaque — F24

**Fig. 5**

$V_{CO}$ (V)

2,15

2,1

2,0

2,0

1,9

1,9

1,9

1,8

0   10   20   30   40   50   60   70   80   90   100   SOC$^2$ (%)

············ $t_2 = 2$ h

─··─ $t_2 = 300$ s

──── $t_2 = 180$ s

──── $t_2 = 120$ s

─·─· $t_2 = 0$ s

**Fig. 6**

**Fig. 7**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4912416 A
- JP 2979938 B

- US 20070194756 A

**Littérature non-brevet citée dans la description**

- **MEISSNER et al.** *Journal of Power Sources,* 2003, vol. 116, 79-98